# EUROPEAN PATENT APPLICATION

(11) **EP 3 021 646 A1**
(43) Date of publication of application: **18.05.2016**
(21) Application number: 14192742.6
(22) Date of filing: 11.11.2014
(51) Int. Cl.: H05K 1/02, H05K 9/00

(54) **A device, system and method for obtaining an emc barrier**

(71) Applicant: Shenzhen Mindray Bio-Medical Electronics Co., Ltd., Shenzhen 518057 (CN)
(72) Inventor: Svedmyr, Peter, 16766 Bromma (SE); Werner, Johan, 14252 Skogås (SE)
(74) Representative: KIPA AB

(57) **Abstract**

A device, system and method for providing an EMC barrier. The EMC barrier comprises a printed circuit board having at least two inner layers and a first and a second outer layer. Each layer is connected to ground. The first outer layer is connected to at least one of the at least two inner layers by a blind via and the second layer is connected to at least one of the at least two inner layers by a blind via, thereby allowing a signal to be transferred from the first outer layer to the second outer layer.

## Description

### BACKGROUND OF THE INVENTION

### Field of the Invention

This disclosure pertains in general to an EMC barrier. More particularly the disclosure relates to an EMC barrier comprising a printed circuit board for separating a first area, such as a filter area and/or an interface area, and a shielded area. In particular this relates to an EMC barrier to be at least partly arranged as a part of an outer wall of a shielding housing.

### Description of the Prior Art

To avoid disturbance from EMC or EMI there has to be a shielding housing around electronic components of a system. Any non-grounded metallic structure passing through the shield may transmit EMC or EMI signal to the electronic components. This includes all electronic wires. All electronic signals, i.e. all in-coming and out-going signal including power and ground, which passes the shield have to be filtered to remove the EMC or EMI signal.

A common used design is to have a shielded area and a filter area with a barrier in between. All signals going in or out of the shielded area are filtered in the filter area. Filter areas are most commonly covered with shield boxes made of metal facing to the outside of the housing. This is not very practical during production since the box have to be soldered every 10mm at least. This is also very impractical during service of the device. Also, an EMC or EMI shield box has to be capable of attenuating oscillating, high frequency electromagnetic disturbances. Typically, an EMC or EMI shield box must be very conductive and fairly thick in order to respond adequately and be considered a reasonable EMC or EMI shield.

Another concept is to divide the housing into two zones, the shielded area and the filter area. In between those areas an EMC barrier is arranged. The barrier may have the appearance of a comb of metal coming up though the printed circuit board assembly (PCBA). The filter area side of the PCBA holds the incoming connector and all EMC filters. Both sides of the filter area have a chassis ground plane that is grounded to the shielding housing. All signals are connected to an EMC filter. Directly after the filter the signals are routed into an inner layer shielded by the two grounded planes of the filter area, and passed through the EMC barrier, i.e. the metal comb. In this way the wire is protected from disturbing radiation. The exposed area after the filter must be kept to a minimum. In this way the PCB works as a coax for the wire. The benefit of this design is that you do not need any shield boxes.

The drawback of this concept is, for example, the need and the assembly of the comb. To assemble and mount the comb to the PCB, holes have to be made through the board. The holes may weaken the board, making the PCB more sensitive to physical forces. The comb is also space consuming and restricts the possibilities of reducing the size of the EMC-barrier

Hence, an improved EMC barrier would be advantageous, and in particular an EMC barrier that has an improved immunity to EMC. Preferably the EMC barrier should be easy to produce and service, and comprise few parts as well as being more compact.

### SUMMARY OF THE DISCLOSURE

Accordingly, examples of the present disclosure preferably seek to mitigate, alleviate or eliminate one or more deficiencies, disadvantages or issues in the art, such as the above-identified, singly or in any combination by providing a device, system or method according to the appended patent claims for providing an improved EMC barrier.

According to one aspect of the disclosure, an EMC barrier is disclosed. The EMC barrier comprises a multi-layer printed circuit board having at least one inner layers and a first and a second outer layer arranged on either side of the multi-layer printed circuit board. Each of the layers are connected to ground. The first outer layer is connected to at least one of the at least one inner layers by a first blind via and the second outer layer is connected to at least one of the at least one inner layers by a second blind via, for transferring a signal from the first outer layer to the second outer layer.

As all layers are grounded, the inner layers are grounded all around. As the electric signal to be transmitted from a noise area, such as a filter area or a connector interface, to a shielded area is not transmitted straight through the PCB through a single through via, the EMC or EMI signal are prevented from being transmitted into the shielded area. This arrangement thereby provides for a small and effective EMC or EMI barrier having few components.

In one example of the disclosure, electric signal from the noise area is directly transmitted to one of the at least one inner layers.

As the filters and/or connectors may be fitted on the first outer layer, the design provides shorter paths for transmitting an electronic signal between the filters and/or connectors to a via that transmits the signal to an inner layer compared to other known EMC barrier. The shorter the paths the less EMC signal is picked up and transmitted with the electronic signal.

In a further example of the disclosure, the multi-layer printed circuit board comprises at least two inner layers, and at least two of the at least two inner layers are connected by a buried via.

More inner layers improve the EMC filtering. Thus the immunity against transmitting EMC signal through the EMC barrier to the shielded area increases.

By using buried vias the position of the transmission point between different layers for the electronic signal may be shifted. The shifting of the transmission point further improves the filtering. The filtering effect of the electronic signal is increased by the every shifting of a transmission point.

In a further example of the disclosure, wherein at least one inner layer, the first outer layer and the second outer layer are all connected to ground via at least one edge of the printed circuit board by connection to a shielding housing.

In a further example of the disclosure, wherein at least one of the first and second outer layer is grounded to a shielding housing and all other layers are grounded by at least one through via connecting the at least one grounded outer layer with the all other layers.

One advantage with the EMC barrier disclosed herein is that the barrier may be at least partly arranged as a part of an outer wall of the shield housing.

One example of achieving this is to connect the printed circuit board to ground by arranging the printed circuit board in a shielding housing by using a slot in the shielding housing.

The slot will have an inner surface that may overlap with at least one of the outer layers of the printed circuit board. This may tighten the EMC barrier. Thus EMC radiations are prevented from being transmitted around the edges of the PCB.

According to a further aspect of the disclosure, a shielding housing is disclosed. The shielding housing comprises a housing defining a shielded area and an EMC barrier which is at least partly arranged as a part of an outer wall of the housing.

In one example of the disclosure the shielding house comprises a nipple configuration that includes nipples made of an electrically conductive material for transmitting a fluid into the shielding housing. The nipples are arranged so that they do not extend into the shield area.

By this arrangement of the nipples, the nipples may not function as antennas transmitting an EMC or EMI signal into the shielded area inside the Shielding housing.

According to another aspect of the disclosure, a method of providing an EMC barrier is disclosed. The method comprising arranging a multi-layered printed circuit board separating a noise area from a shielded area, the multi-layered printed circuit board having at least one inner layers and a first and a second outer layer arranged on either side of the multi-layer printed circuit board, and wherein each layer is connected to ground. The first outer layer is connected to at least one of the at least one inner layers by a blind via and the second outer layer is connected to at least one of the at least one inner layers by a blind via, for transferring a signal from the first outer layer to the second outer layer.

It should be emphasized that the term "comprises/comprising" when used in this specification is taken to specify the presence of stated features, integers, steps or components but does not preclude the presence or addition of one or more other features, integers, steps, components or groups thereof.

### BRIEF DESCRIPTION OF THE DRAWINGS

These and other aspects, features and advantages of which examples of the disclosure are capable of will be apparent and elucidated from the following description of embodiments of the present disclosure, reference being made to the accompanying drawings, in which
Fig. 1A and 1B are illustrating exemplary cross-sections of EMC barriers;
Fig. 2 is illustrating an exemplary cross-section of an EMC barrier arranged in a shielding housing;
Fig. 3A and 3B are illustrating an exemplary configuration of an EMC barrier grounded by a slot; and
Fig. 4A and 4B are illustrating an exemplary configuration of shielded area including pneumatic nipples.

### DESCRIPTION OF EMBODIMENTS

Specific examples of the disclosure will now be described with reference to the accompanying drawings. This disclosure may, however, be embodied in many different forms and should not be construed as limited to the examples set forth herein; rather, these examples are provided so that this disclosure will be thorough and complete, and will fully convey the scope of the disclosure to those skilled in the art.

While several examples of the present disclosure have been described and illustrated herein, those of ordinary skill in the art will readily envision a variety of other means and/or structures for performing the functions and/or obtaining the results and/or one or more of the advantages described herein, and each of such variations and/or modifications is deemed to be within the scope of the present disclosure. The scope of the disclosure is only limited by the appended patent claims.

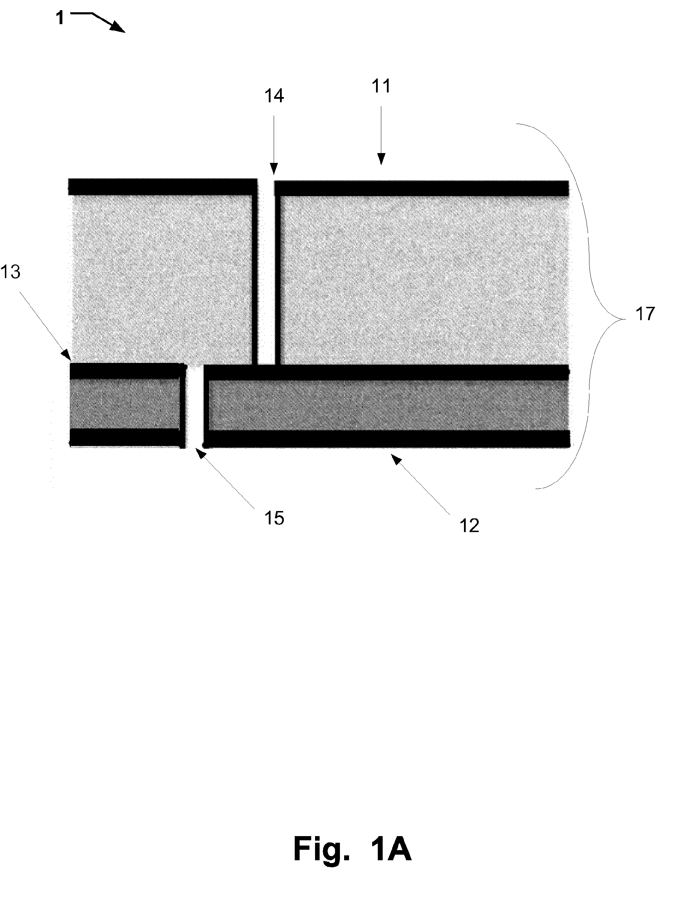

Figure 1A is illustrating exemplary cross-section of an EMC barrier 1. The EMC barrier comprises a multi-layer printed circuit board (PCB) 17. The multi-layer PCB 17 has at least one inner layer 13 and a first outer layer 11 and a second outer layer 12. The outer layers 11, 12 are arranged on either side of the multi-layer PCB 17. Both the outer layers 11, 12 and the at least one inner layer 13 are connected to ground. The inner layer 13 has thereby ground all around.

The first outer layer 11 is connected to at least one of the at least one inner layers 13 by a first blind via 14 and the second outer layer 12 is connected to at least one of the at least one inner layers 13 by a second blind via 15. An electronic signal is thereby transferable via the vias from the first outer layer 11 to the second outer layer 12 and vice versa.

The multi-layer PBC 17 separates a noise area at the first outer layer 11 from a shielded area at the second outer layer 12. The noise area may, for example be a filter area. Additionally and/or alternatively, the noise area may be a connector area.

The vias will function as selective vias and only transmit the electronic signal and prevent transmission of an EMC signal. As there are no through vias that transfer an electronic signal and all layers are grounded the EMC signal is prevent from being transferred from the first outer layer 11 to the second outer layer 12.

This arrangement of an EMC barrier has en improved immunity to EMC or EMI radiation. Further, the EMC barrier has less components than the EMC barriers in the prior art because no extra shield boxes or combs are needed. The device is therefore easier to serve and the device can be made more compact as no space requiring features, such as a shield box or a comb, is needed to archive EMC immunity.

Additionally, in some examples, the first outer layer 11 of the multi-layer PCB 17 may hold connectors and/or filters and the second outer layer 12 is positioned in a shielded area.

Additionally, in some examples, the electronic signal from the noise area, such as an electronic from a connector and/or a filter, is directly connected to one of the inner layers which have ground all around. As the filters and/or connectors may be fitted on the first outer layer, the design provides shorter paths for transmitting an electronic signal between the filters and/or connectors to a via that transmits the signal to an inner layer compared to other known EMC barrier. The shorter the paths the less EMC signal is picked up and transmitted with the electronic signal.

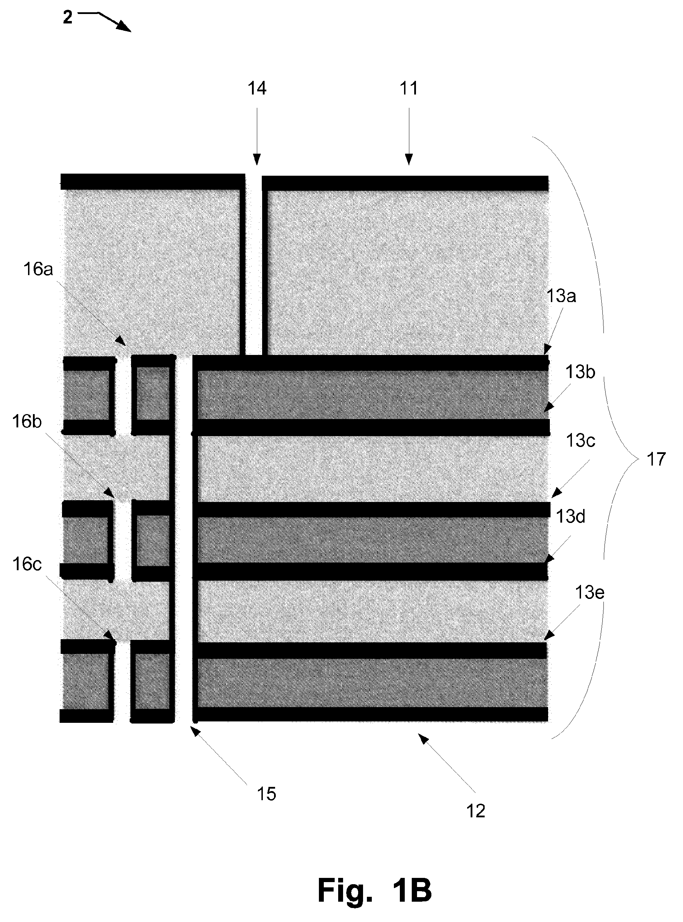

Figure 1B is illustrating exemplary cross-section of an EMC barrier 2. The EMC barrier 2 in figure 1B functions as the EMC barrier 1 of figure 1A. The difference is that multi-layer PCB 17 of the EMC barrier 2 has multiple inner layers 13a-13e. All the inner layers 13a-13e are grounded.

In some examples, some of the inner layers 13a-13e may be connected by buried vias 16a-16c for transferring a signal between two or more inner layers. More inner layers improve the EMC filtering. Thus the immunity against transmitting EMC signal through the EMC barrier to the shielded area increases.

By using buried vias the position of the transmission point between different layers for the electronic signal may be shifted. The shifting of the transmission point further improves the filtering. The filtering effect of the electronic signal is increased by the every shifting of a transmission point.

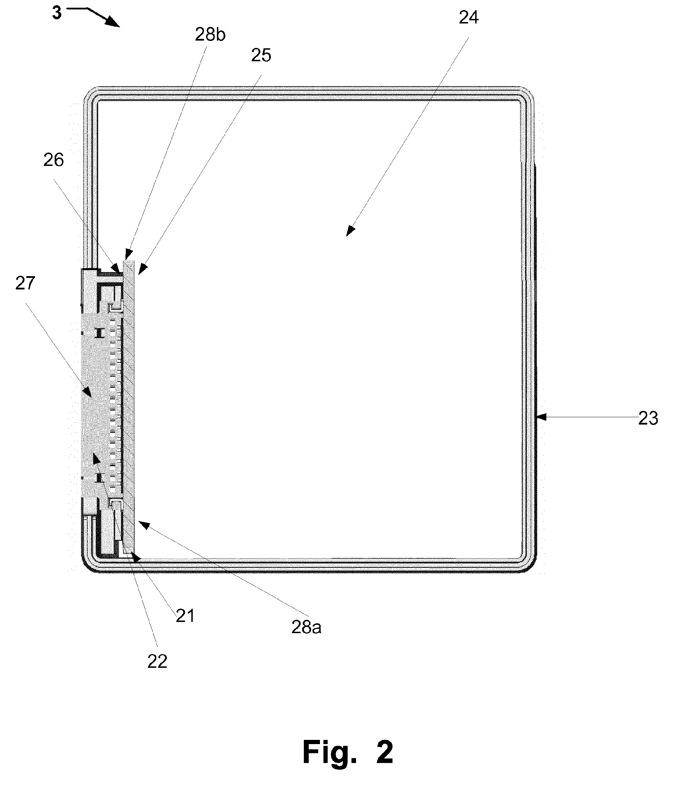

Figure 2 is illustrating an exemplary arrangement for obtaining a shielded area 3. An EMC barrier 21 is arranged as part of a wall of housing 23. The housing 23 may be a shielding housing made of, for example, metal, including metal sheet and foil or nonmetallic materials, such as plastic materials with conductive coating, conductive plastic, or a combination of these two plastic materials through coinjection. The EMC barrier 21 has a first outer layer 26 and a second outer layer 25. The first outer layer 26 is exposed to EMC and/or EMI and is connected to, in the example as illustrated, a connection interface and filters 27 at a filter area 22. The second outer layer 25 is arranged in a shielded area 24. All outer layers and the inner layers of the multilayer PCB of the EMC barrier 21 are grounded.

In one example, the inner layer (not illustrated in figure 2), the first outer layer 26, and the second outer layer 25 are all connected to ground via at least one edge 28a, 28b of the multi-layered PBC. In the illustration only the top edge 28a and the bottom edge 28b is illustrated, but any edge of the EMC barrier 21 may be used to connect the layers of the multi-layer PCB to ground.

Connecting the EMC barrier 21 to ground may, for example, be done by connecting all layers at the edge of the multi-layered PCB to a housing 23. The layers may be connected to the housing 23 in different way, for example, by direct contact of the edge with the housing 23, or by connection means, such as at least one wire connecting the edge of the PCB and the housing 23.

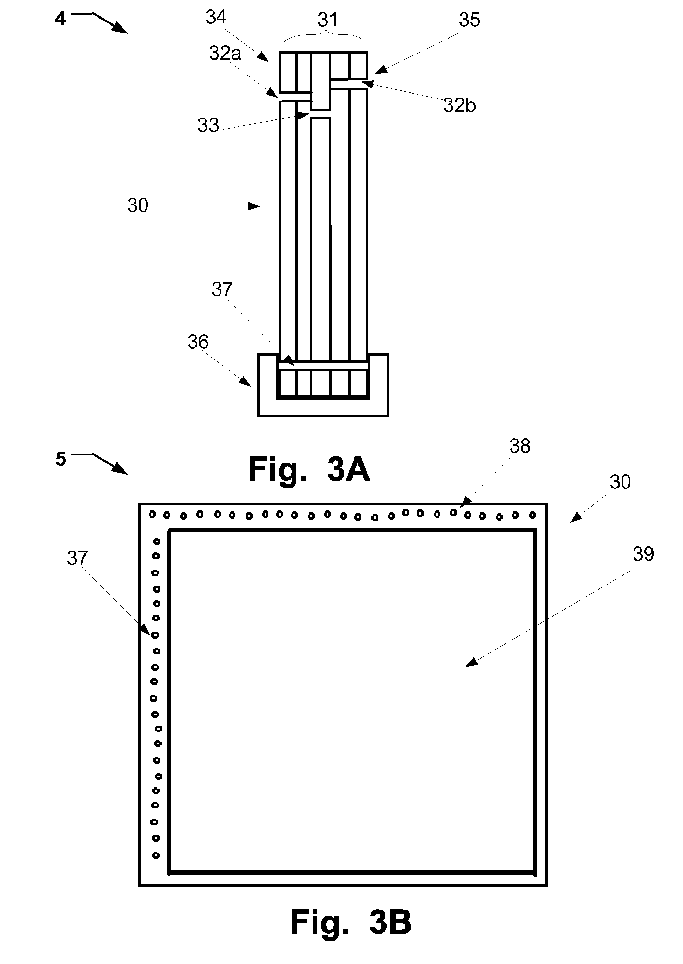

In figure 3A is another example of grounding the layers of the EMC barrier 4 illustrated. The PCB 30 of the EMC barrier 4 may be arranged in a slot 36. The slot 36 may be a groove in the housing or alternatively a separate U-shaped socket arranged on one wall of the housing. The slot is connected to ground. The slot 36 may ground the EMC barrier 4at the edges of at least one side, such as all four sides, of the PCB 30.

When the PCB 30 is arranged in the slot 36 the inner surfaces of the slot 36 may be in contact with the first outer layer 34 and/or the second outer layer 35, thereby is an overlap provided between the inner surfaces of the slot 36 and the PCB 30 that tightens the EMC barrier 4. Thus EMC radiations are prevented from being transmitted around the edges of the PCB 30.

The inner layers 31 may be grounded by having edges of the inner layers contacting a grounded surface of the slot 36.

Alternatively and/or additionally, in another example of grounding the layers of the EMC barrier 4, at least one of a first outer layer 34 or a second outer layer 35 is grounded at an edge of respective layer to, for example, a housing. All other layers are grounded to the housing by at least one through via 37. The at least one through via 37 is connecting all other layers with the grounded first outer layer 34 and/or second outer layer 35. The through via is positioned adjacent the edge of the PCB 30 of the EMC barrier 4.

One way of connecting a first outer layer 34 and/or a second outer layer 35 to the ground may be to connect the edge of the first outer layer 34 and/or the second outer layer 35 with at least one grounded surface, such a grounded surface may be in contact with the housing or be a part of the housing itself.

The at least one of the openings of the at least one through via 37 may be covered by the grounded surface extending onto the first outer layer 34 and/or second outer layer 35. As at least one of the openings of each of the at least one through via 37 is covered by an overlapping grounded surface, the EMC signal is prevented from being transmitted through the at least one via 37 from a noise area, such as a filter area, to a shielded area.

Alternatively, in some examples of grounding the layers of the EMC barrier 4, buried vias or blind vias are used instead of through vias 37 to connect all layers of the PCB 30 with the ground. At least one buried via or blind via may connect a grounded first outer layer 34 and/or second outer layer with the other layers, such as the inner layers 31, to connect them to ground. By using blind vias or buried vias there will be no open connect through the PCB 30 that could transmit an EMC signal through the EMC barrier 4. Thus, the overlapping grounded surface does not need to cover the blind or buried vias.

Figure 3B is illustration one way of grounding a PCB board 30 of an EMC barrier 5.

Vias 37, which may be through, buried or blind vias, are in this example positioned adjacent to the edge of the PCB 30. The edge of the PCB 30 may be covered by a conductive material 38 to be connected to the ground, such as a conductive metal. In this illustration the vias 37 are arranged along two edges of the PCB 30. The vias 37 may be arranged in other configurations, such as only one via, or vias 37 only along one edge, or vias 37 along three edges, or vias 37 along all four edges.

The same applies to the conductive material 38, such as a conductive metal, if needed provide a contact between an outer layer and ground. In figure 3B the conductive material is arranged along all four edges but other ways are possible, such as along three, two or one edge, as long as the conductive material 38 is arranged in connection to the vias 37.

The conductive material 38 is applied to the outer layers that are connected to the ground.

Arranging the vias 37 adjacent to the edge may not only prevent the EMC signal to pass through the vias 37 from one side to the other as the vias 37 may be covered by an overlapping grounded surface. It may also function as an EMC shield preventing any EMC signal from being transmitted from the edge of the PCB 30 and between the inner layers 31 to the central part 39 where the electronic signal is transmitted form a noise area, such as a filter area or connector area, to a shielded area.

Further, a method of providing an EMC barrier is disclosed herein. The method comprising arranging a multi-layered printed circuit board (PCB) for separating a noise area from a shielded area. The multi-layered printed circuit board having at least one inner layer and a first and a second outer layer arranged on either side of the multi-layer printed circuit board. Each layer is connected to ground and the first outer layer 34 is connected to at least one of the at least one inner layers 31 by a blind via 32a. The second outer layer 35 is connected to at least one of the at least one inner layers by a blind via 32b. By this arrangement an electronic signal can be transferred from the first outer layer to the second outer layer and at the same time preventing the EMC signal from being transmitted through the EMC-barrier.

The advantages of such a method are the same as for the device and system described herein above.

Additionally, in some examples, the method comprising using a PCB which connects at least two inner-layers by a buried via 33. Further, in some examples, the method may comprising directly connecting the electronic signal from a filter area and/or connector area being the noise area, to one of the at least one inner layers.

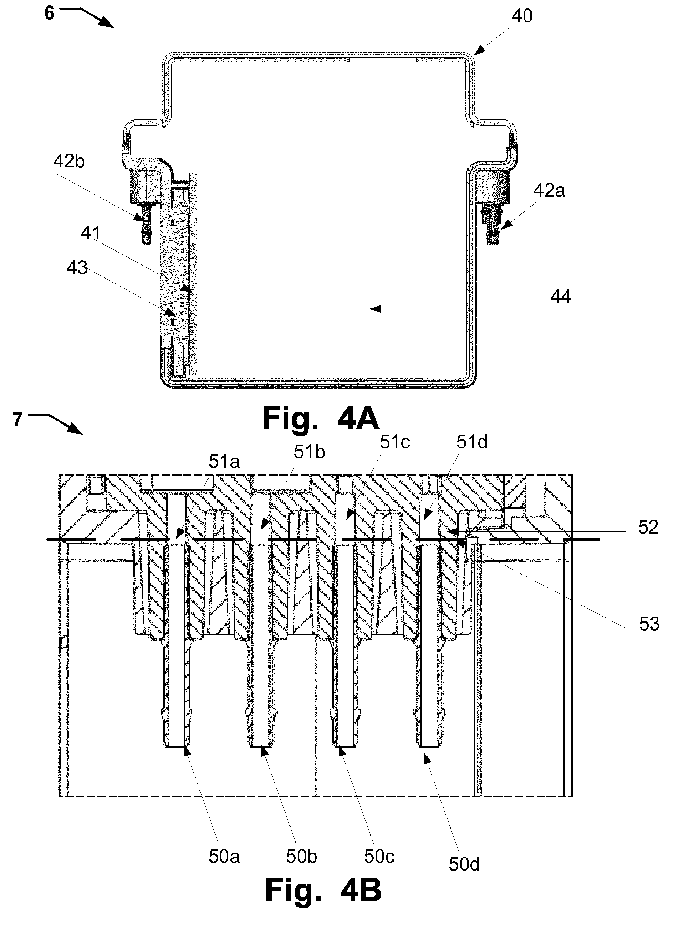

Figure 4A illustrates an arrangement 6 comprises a housing 40 defining a shielded area 44. The housing may be of a electrically conductive metal or by a non-conductive metal having a conductive coating. Alternatively, the housing may be made of plastic materials with conductive coating, conductive plastic, or a combination of these two plastic materials through coinjection. The arrangement 6 further comprises an EMC barrier 41 which is at least partly arranged as a part of an outer wall of the housing 40. The EMC barrier has an outer layer with filters and/or connectors 41.

Additionally, in some examples, the housing 40 has at least one nipple configuration 42a, 42b. Figure 4A illustrates an arrangement 6 having two nipple configurations 42a, 42b but other configurations are possible, such as only one nipple configuration having only one nipple. The nipples may be used for attaching a host or a tube for connecting a flow of a fluid in and/or out of the housing 40. For example, the nipples may be used for connecting a flow of a fluid to and from a pneumatic system, such as a pneumatic block.

A nipple configuration may comprise nipples made of an electrically conductive material. To prevent the nipples to function as antennas and transmit an EMC signal from a noise area outside of the housing 40 to the shielded area 44, the nipples are arranged so that they do not passes into the shielded area 44.

In figure 4B one of the nipple configurations 7 is illustrated in more details. In this example the nipple configuration 7 has four nipples 50a to 50d. This illustration is only used for the purpose of illustrating the method used and is not limited to any specific number of nipples. A nipple configuration 7 may have more or less nipples than what is being illustrated here.

The nipples 50a to 50d are arranged in holes 51a to 51d in a non-conductive material 52. The dashed line 53 illustrates where the opening in the housing ends for accommodating the nipple configuration 7. As showed in this figure, none of the nipples extends over this dashed line 53 and into the housing. As no nipple extends over the dashed line 53 and into the housing they could not transmit any EMC signal into the housing.

While several examples of the present disclosure have been described and illustrated herein, those of ordinary skill in the art will readily envision a variety of other means and/or structures for performing the functions and/or obtaining the results and/or one or more of the advantages described herein, and each of such variations and/or modifications is deemed to be within the scope of the present disclosure. More generally, those skilled in the art will readily appreciate that all parameters, dimensions, materials, and configurations described herein are meant to be exemplary and that the actual parameters, dimensions, materials, and/or configurations will depend upon the specific application or applications for which the teachings of the present disclosure is/are used. Also, different method steps than those described above, performing the method by hardware, may be provided within the scope of the disclosure. The different features and steps of the disclosure may be combined in other combinations than those described. The scope of the invention is only limited by the appended patent claims.

## Claims

1. An EMC barrier comprises a multi-layer printed circuit board having at least one inner layers and a first and a second outer layer arranged on either side of said multi-layer printed circuit board, and wherein each layer is connected to ground;
said first outer layer is connected to at least one of said at least one inner layers by a first blind via and said second outer layer is connected to at least one of said at least one inner layers by a second blind via, for transferring a signal from said first outer layer to said second outer layer.

2. The EMC barrier according to claim 1, wherein said printed circuit board separates a noise area, such as a filter area, from a shielded area.

3. The EMC barrier according to claim 2, wherein said noise area comprises a connector interface, and/or comprises filters.

4. The EMC barrier according to any of claims 2 to 3, wherein said signal from said noise area is directly transmitted to one of said at least one inner layers.

5. The EMC barrier according to any of claims 1 to 4, wherein each inner layer is grounded all around.

6. The EMC barrier according to any of claims 1 to 5, wherein said multi-layer printed circuit board comprises at least two inner layers, and at least two of said at least two inner layers are connected by a buried via.

7. The EMC barrier according to any of claims 1 to 6, wherein said at least one inner layer, said first outer layer and said second outer layer are connected to ground via at least one edge of said printed circuit board by connection to a shielding housing.

8. The EMC barrier according to any of claims 1 to 7, wherein at least one of said first and second outer layer is grounded to a shielding housing and all other layers are grounded by at least one through via connecting said at least one grounded outer layer with said all other layers.

9. The EMC barrier according to any of claims 1 to 8, wherein said printed circuit board is at least partly arranged as a part of an outer wall of said shield housing.

10. The EMC barrier according to any of claims 7 to 9, wherein said printed circuit board is grounded to said shielding housing by a slot or groove in the shielding housing.

11. A shielding housing comprising:
a housing defining a shielded area;
an EMC barrier, such as en EMC barrier according to any of claims 1 to 10, which is at least partly arranged as a part of an outer wall of said housing.

12. The shield housing according to claim 11, comprises a nipple configuration comprising nipples made of an electrically conductive material for transmitting a fluid into the housing; and
wherein said nipples are arranged so that they do not extend into said shield area.

13. A method of providing an EMC barrier comprising:
arranging a multi-layered printed circuit board separating a noise area from a shielded area, said multi-layered printed circuit board having at least one inner layers and a first and a second outer layer arranged on either side of said multi-layer printed circuit board, and wherein each layer is connected to ground, said first outer layer is connected to at least one of said at least one inner layers by a blind via and said second outer layer is connected to at least one of said at least one inner layers by a blind via, for transferring a signal from said first outer layer to said second outer layer.

14. The method of claim 13, comprising directly connecting said signal from a filter area and or connector area being said noise area to one of said at least two inner layers.

15. The method according to any of claims 13 or 14, comprising, connecting at least one inner layers by a buried via.
